# EUROPÄISCHE PATENTANMELDUNG

(11) **EP 1 835 525 A1**
(43) Veröffentlichungstag der Anmeldung: **19.09.2007**
(21) Anmeldenummer: 07102527.4
(22) Anmeldetag: 16.02.2007
(51) Int. Cl.: H01J 37/34

(54) **Targethaltevorrichtung**

(30) Priorität: 16.03.2006 EP 06405117
(71) Anmelder: Sulzer Metco AG (Switzerland), 5610 Wohlen (CH)
(72) Erfinder: Beele, Dr., Wolfram, 40883, Ratingen (DE); Eschendorff, Gerald, 5913, TE Venlo (NL)
(74) Vertreter: Sulzer Management AG

(57) **Zusammenfassung**

Eine Vorrichtung zur Befestigung von einem Target oder Targetsegment (9) einer Beschichtungsquelle umfasst ein Target oder Targetsegment (9) und eine Targethaltevorrichtung (1), welche einen Kühlkörper (13) und Verbindungsmittel (6,7,8,11) zur Befestigung des Targets oder Targetsegments am Kühlkörper umfasst. Die Verbindungsmittel umfassen (3,6,7,8,10,11) elektrisch und/oder thermisch leitfähige Mittel, sodass die Stromzufuhr gleichmässig über das Target oder Targetsegment erfolgt, sowie die während des Beschichtungsverfahrens am Target oder Targetsegment entstehende Wärme gleichmässig in den Kühlkörper abführbar ist, wodurch mehr Leistung in die Beschichtungsquelle eingekoppelt werden kann und die Beschichtungsrate erhöht wird.

## Beschreibung

Die Erfindung betrifft eine Targethaltevorrichtung für ein Target, welche in einem Beschichtungsverfahren Einsatz findet. Das Beschichtungsverfahren umfasst insbesondere ein Gasflusssputterverfahren zur Aufbringung von hochtemperaturbeständigen Haftschichten auf ein Substrat, wie insbesondere auf eine Turbinenschaufel. Das Target enthält das Beschichtungsmaterial, welches durch Ionen eines ionisierten Inertgasplasmas aus dem Target abstäubbar sind. Die Targets sind auf Targethaltern im Gehäuse einer Beschichtungsquelle untergebracht. Das vom Target abgestäubte Beschichtungsmaterial gelangt mittels des ionisierten Inertgasplasmastroms zu dem zu beschichtenden Substrat. Die Beschichtungsquelle befindet sich einer geschlossenen Vakuumkammer, welche kontinuierlich abgepumpt wird. Das ionisierte Inertgas und die abgeschiedenen Beschichtungspartikel des Targets gelangen innerhalb der Kammer zum Substrat bzw. werden durch die Vakuumpumpe abgesaugt. Jedes Target muss in dem Targethalter mechanisch befestigt werden, wodurch im Target Spannungen auftreten. Derartige Spannungen sind im Target unerwünscht, weil das Beschichtungsmaterial, aus welchem das Target besteht, weder gegen Zugnoch gegen Druck- oder Torsionsspannungen beständig ist. Beim Beschichtungsmaterial handelt es sich in der Regel um zumindest teilweise versinterte Pulver oder um Schmelzen.

Ein Target wird auf einen Targethalter aufgelötet oder direkt mit dem Targethalter verschraubt. Eine mögliche Lösung besteht darin, ein Sackloch in den Targethalter zu bohren, in welches das Target geschraubt wird. Das Target ist im Betrieb einem hohen Wärmeeintrag ausgesetzt. Diese Wärme muss über den Targethalter abgeführt werden. Sowohl bei einer Lötverbindung, als auch bei einer Einschraublösung können insbesondere in Temperaturbereichen oberhalb 400°C Überhitzungen im Target auftreten, da die Wärme nicht über die Kontaktflächen der Lötverbindung oder der Schraubverbindung abgeführt werden kann. Derartige Überhitzungen haben zur Folge, dass hohe Eigenspannungen im Target entstehen, die zu einer Rissbildung und demzufolge zum vorzeitigen Ausfall des Targets führen.

Aufgabe der Erfindung ist es daher, ein Target oder Targetsegment mittels einer Targethaltevorrichtung derart an das Kühlsystem anzubinden, dass derartige Überhitzungen nicht mehr auftreten.

Die Lösung der Aufgabe erfolgt durch den kennzeichnenden Teil von Anspruch 1. Eine Vorrichtung zur Befestigung von einem Target oder Targetsegment einer Beschichtungsquelle umfasst ein Target oder Targetsegment und eine Targethaltevorrichtung, welche einen Kühlkörper und Verbindungsmittel zur Befestigung des Targets oder Targetsegments am Kühlkörper umfasst. Die Verbindungsmittel umfassen elektrisch und/oder thermisch leitfähige Mittel, sodass die Stromzufuhr in einer gleichmässigen Verteilung über das Target oder Targetsegment erfolgt, sowie die während des Beschichtungsverfahrens am Target oder Targetsegment entstehende Wärme gleichmässig in den Kühlkörper abführbar ist.

In der Folge soll die Bezeichnung Targetsegment auch stellvertretend für Target verwendet werden. Üblicherweise wird zwar die Bezeichnung Target verwendet, da man bei herkömmlichen Sputterprozessen nur ein einziges Target verwendet. Target steht für ein Element aus Beschichtungsmaterial, welches sich in einer Beschichtungsquelle befindet, die zur Verwendung in einem Beschichtungsverfahren, wie insbesondere einem Gasflusssputterverfahren verwendet wird. Für das Beschichtungsverfahren kommt eine Beschichtungsvorrichtung zum Einsatz, welche die Beschichtungsquelle, sowie das zu beschichtende Substrat umfasst. Die Beschichtungsquelle umfasst die Gesamtheit der Targetsegmente, die Targethaltevorrichtung für jedes Targetsegment, eine Verteilungsvorrichtung für ein Gas, welches ein Inertgas, insbesondere Argon oder ein Reaktivgas, insbesondere in sauerstoffhältiges Gas umfasst. Weiters umfasst die Beschichtungsquelle einen Kühlkörper mit Kühlmittelanschluss, insbesondere Wasseranschluss sowie ein Gehäuse zur Aufnahme aller oben genannten Komponenten, sowie Mittel zur Isolierung der gesamten Beschichtungsquelle. Diese Mittel zur Isolierung bewirken die vollständige elektrische und weitgehend vollständige thermische Isolierung der Beschichtungsquelle vom Sputterraum. Mit Sputterraum wird der Bereich der Beschichtungsvorrichtung bezeichnet, der zumeist als Vakuumkammer ausgebildet ist, in welcher die Beschichtung abläuft, das heisst, in diesem Bereich der Vakuumkammer befindet sich das zu beschichtende Bauteil oder die zu beschichtenden Bauteile. Das Beschichtungsmaterial ist auf dem Targetsegment angeordnet. Die Beschichtungsquelle kommt insbesondere in einem Gasflusssputterverfahren zum Einsatz, für welches in der Folge die Abkürzungen GF-PVD (gas flow physical vapor deposition) oder auch HS-PVD (high speed physical vapor deposition) verwendet werden soll. Für das Gasflusssputterverfahren, werden zumeist zwei gegenüberliegende Targetsegmente verwendet. Diese Targetsegmente können je nach Grösse und gewünschter Sputterrate als einzelnes Element ausgeführt sein oder aus einer Vielzahl von Einzelsegmenten, eben den vorgenannten Targetsegmenten, bestehen. Somit bedeutet der Ausdruck Targetsegment in dieser Anmeldung anstelle von Target, dass zumindest ein Targetsegment pro Targethaltevorrichtung verwendet wird. Die Segmentierung des Targets erlaubt es, höhere Beschichtungsraten und Leistungseinkopplungen zu erzielen. Sollten höhere Beschichtungsraten und Leistungseinkopplungen von sekundärer Bedeutung sein, kann mit der vorliegenden Anordnung der Beschichtungsquelle im Sputterverfahren auch ohne Segmentierung gearbeitet werden. Durch die Verwendung von Targetsegmenten ist es möglich, eine höhere elektrische Leistung in jedes Targetsegment einzukoppeln, wodurch das Abstäuben von Schichtmaterial vom Targetsegment beschleunigt wird, sodass eine höhere Zerstäubungsrate erzielbar ist. Aufgrund der höheren Zerstäubungsrate ergeben sich höhere Beschichtungsraten am Bauteil. Die Verwendung von Targetsegmenten bietet auch Vorteile, die die Haltbarkeit und mechanischen Eigenschaften der Targetsegmente betreffen. Durch die geringen Spannungen in jedem Targetsegment kommt es nicht zu Rissen oder Brüchen im Beschichtungsmaterial. Somit können auch harte und/oder spröde Beschichtungsmaterialien, wie insbesondere MCrAIY mit der gleichen Leistungseinkopplung beaufschlagt werden, ohne dass eine Änderung in der Handhabung der Beschichtungsmaterialien beim Einbau und während des Beschichtungsverfahrens erforderlich ist. Sehr weiche Materialien, insbesondere reines Aluminium oder Magnesium, die schlecht oder sogar gar nicht gelötet werden können, können mit der gleichen Leistungseinkopplung beansprucht werden, ohne dass eine Änderung in der Handhabung der Beschichtungsmaterialien beim Einbau und während des Beschichtungsverfahrens erforderlich ist. Des weiteren erhöht sich die Temperaturbeständigkeit der Anordnung der Targetsegmente, weil die Wärme besser abgeführt werden kann, wodurch es auf keinem der Targetsegmente zum Schmelzen des Materials kommt. Jedes der Targetsegmente hat insbesondere seinen eigenen Stromanschluss sowie einen eigenen Anschluss an den Kühlkörper. Die Hauptfunktion des Kühlkörpers besteht darin, die auf den Targetsegmenten während des Beschichtungsverfahrens entstehende Wärme abzuführen. Der Leistungseintrag, welcher, verursacht durch Ströme von insbesondere bis zu 150 A je Target, insbesondere Leistungsdichten von insbesondere bis zu 220 W/cm² auf der Targetoberfläche hervorruft, sowie die Stossenergie der auf das Targetsegment auftreffenden Gasatome erzeugen die abzuführende Wärmeenergie. Als Gas kann einerseits in einem Beschichtungsverfahren zur Beschichtung mit einem metallischen Beschichtungsmaterial ein Inertgas zum Einsatz kommen, wobei sich insbesondere Argon als geeignet erwiesen hat. Die Stossenergie dieser Argonatome führt ebenfalls zu einem Wärmeeintrag in das Targetsegment. Durch den Stoss werden Atome des Beschichtungsmaterials aus ihrem Verbund an der Targetsegmentoberfläche herausgelöst. Hierbei werden hohe Temperaturen erreicht. Um den Prozess zu kontrollieren, kann zusätzlich mittels einer Strahlungsheizvorrichtung geheizt werden, um Beschichtungstemperaturen je nach Substrat und Schicht von insbesondere bis zu ca. 1150 Grad Celsius in der Beschichtungskammer zu erzielen. Die Beschichtungsvorrichtung kann auch für reaktives Gasflusssputterverfahren zum Einsatz kommen. Anstatt oder zusätzlich zum Inertgas wird Reaktivgas, insbesondere sauerstoffhältiges Gas zugeführt, wodurch es zu Reaktionen des Beschichtungsmaterials mit den Gasmolekülen am Targetsegment oder in der Gasphase nach Ablösung vom Targetsegment kommt, sodass es durch die meist exotherm ablaufenen chemischen Reaktionen, insbesondere Oxidationsreaktionen zur Temperaturerhöhung kommt. Um eine Überhitzung des Targetsegments bei einer Beschichtungsdauer von einigen Stunden zu vermeiden, wird jedes Targetsgment gekühlt, wobei insbesondere Wasserkühlung zum Einsatz kommt. Für die Einkopplung höherer Ströme, die höheren Wärmeübergang am Targetsegment zur Folge haben, ist es vorteilhaft, eine Vielzahl von einzelnen Targetsegmenten in der Beschichtungsvorrichtung zu verwenden. Um die oben genannten Spannungen im Targetsegment zu vermeiden oder soweit zu verringern, dass sie unterhalb der Rissbildungsspannung des Targetsegmentmaterials liegen, wird die im folgenden beschriebene erfindungsgemässe Targethaltevorrichtung verwendet.

Die Beschichtungsquelle umfasst somit das oder die Targetsegmente, den Stromanschluss für jedes der Targetsegmente, einen Anschluss jedes der Targetsegmente an das Kühlsystem zur Zu- und Ableitung eines Kühlmittels. Die Zufuhr des Inertgases und/oder Reaktivgases erfolgt über Gasanschlüsse, sowie Gasverteiler, welche derart angeordnet sind, dass eine gleichmässige Verteilung der Gasmenge mit einer gleichen mittleren Auftreffgeschwindigkeit auf alle Targetsegmente erfolgt. Apparativ ist jedes Targetsegment in einer Targethaltevorrichtung aufgenommen. Die Targethaltevorrichtung umfasst den oder die Kühlkörper, sowie eine Aussenwand, sowie Verbindungsmittel zur Anbindung des Targetsegments an den Kühlkörper sowie der Aussenwand der Beschichtungsquelle. Durch den vorher beschriebenen Aufbau der Beschichtungsquelle sind Targetsegmente, aber auch andere Teile der Beschichtungsquelle, wie Gasverteilungseinheit, Aufnahmeeinheiten für Beschichtungsmaterial, welches nicht vom Gasstrom aus der Beschichtungsquelle transportiert wurde, unabhängig voneinander ein- und ausbaubar, sodass eine verbesserte Wartung und Reinigung der Targetsegmente, sowie anderer Teile der Beschichtungsquelle erzielbar ist. Dieser Tatsache kommt bei Hochleistungseinsätzen, sowie bei Langzeiteinsätzen der Beschichtungsquelle eine besondere Bedeutung zu. Sollte es zu einem Schaden an einem Targetsegment kommen, der zu einem Ausfall der Beschichtungsquelle führt, ist es möglich, den Schaden schnell durch das Auswechseln des Targetsegments zu beheben. Dadurch ergibt sich ein Kostenvorteil, weil alle anderen Targetsegmente weiter verwendet werden können. Der Anteil an nicht mehr verwendbarem Beschichtungsmaterial umfasst maximal das Beschichtungsmaterial des zu ersetzenden Targetsegments. Der Zeitaufwand für das Auswechseln des Targetsegments wird verringert, da nur das beschädigte Targetsegment auszuwechseln ist und durch die erfindungsgemässe Targethaltevorrichtung jedes Targetsegment einzeln auswechselbar ist. Jeder Bestandteil der Targethaltevorrichtung ist ebenfalls unabhängig von den übrigen Teilen der Beschichtungsquelle auswechselbar. Eine Folge dieser Wartungsfreundlichkeit ist die Wiederverwendbarkeit der Targethalter und/oder Targetsegmente über ihre gesamte Lebensdauer. Der Ausfall eines Targethalters und/oder Targetsegments hat nur eine kurze Stillstandszeit der Beschichtungsanlage zur Folge, wodurch es gerade bei Anwendungen in der Serienfertigung allenfalls zu geringen Produktionsunterbrechungen kommt. Durch die Austauschbarkeit der Targetsegmente können auch Beschichtungsaufgaben unter Verwendung unterschiedlichen Beschichtungsmaterialien in derselben Beschichtungsanlage realisiert werden. Die Targetsegmente können aus beliebigen Beschichtungsmaterialien aufgebaut sein, sodass ein Target Targetsegmente aus unterschiedlichen Beschichtungsmaterialien aufweisen kann. Die Umrüstung des gesamten Targets auf ein neues Beschichtungsmaterial ist durch die erfindungsgemässe Targethaltevorrichtung vergleichsweise unproblematisch, da die Targets schnell austauschbar sind. Die Dimensionen der Targetsegmente können ebenfalls in weiten Bereichen variieren, sodass durch die Dimensionierung der Targetsegmente, die Anordnung der Targetsegmente, sowie die Variation der Gasverteilung durch verschiebbare Gasverteilungseinheiten oder eine Durchflussänderung in der Gasverteilungseinheit die Zusammensetzung der Beschichtung auf dem Bauteil genau einstellbar ist.

Weitere vorteilhafte Ausgestaltungen der Erfindung sind Gegenstand der Unteransprüche. Die Vorrichtung nach umfasst eine T-Mutter zur Aufnahme einer Befestigungsschraube zur Verbindung von Targetsegment mit dem Kühlkörper.

Die T-Mutter und/oder die Befestigungsschraube weisen eine Kontaktlamelle auf, wobei durch die Kontaktlamelle ein strom-und wärmeleitender Kontakt zwischen T-Mutter und Befestigungsschraube und/oder Targetsegment herstellbar ist.

Die T-Mutter weist eine galvanische Beschichtung im Kontaktbereich von T-Mutter mit Befestigungsschraube und/oder T-Mutter und Kühlkörper und/oder T-Mutter und Targetsegment auf. Der Kühlkörper und/oder das Targetsegment weisen zumindest an den gemeinsamen Kontaktflächen eine galvanische Beschichtung auf.

Die Befestigungsschraube ist im Bereich der Durchtrittsbohrung durch den Kühlkörper von einer Hülse umgeben, wobei die Hülse als hohlzylindrischer Körper ausgebildet sein kann, der insbesondere ein Aussengewinde enthält, womit die Hülse in eine Bohrung im Kühlkörper einschraubbar ist und durch welche die Befestigungsschraube passgenau hindurchsteckbar ist, oder die Hülse zusammen mit der Befestigungsschraube in eine Gewindebohrung des Kühlkörpers einschraubbar ist, sodass ein guter Wärmeübergang von der Befestigungsschraube in den Kühlkörper zur Ableitung der Wärme vom Targetsegment erfolgt. Die Hülse wird in der Fachsprache auch als Einschraublamelle oder Einschraublamellenhülse bezeichnet.

Die elektrisch und/oder thermisch leitfähigen Mittel umfassen eine Gabelsteckvorrichtung zum Einstecken eines Targetsegments in den Kühlkörper.

Eine Kontaktlamelle ist zwischen Targetsegment und Kühlkörper angeordnet, insbesondere innerhalb der Gabelsteckvorrichtung und/oder in einer Ausnehmung des Kühlkörpers und/oder des an den Kühlkörper anschliessenden Targetsegments und/oder der zwischen Kühlkörper und Targetsegment angeordneten T-Mutter.

Die Kontaktlamelle umfasst ein Federelement, wodurch der Wärmeübergang zwischen den benachbarten Oberflächen des Kühlkörpers und/oder des Targetsegments und/oder T-Mutter und/oder der Gabelsteckvorrichtung verbesserbar ist.

Die Gabelsteckvorrichtung ist auf den Kühlkörper aufgelötet und/oder, in einer Ausnehmung des Targetsegments eingesteckt und/oder mit dem Kühlkörper verschraubbar. Zumindest ein Kühlmittelkanal ist zur Förderung des Kühlmittels durch den Kühlkörper vorgesehen. Der Kühlkörper umfasst zumindest einen Einlass und einen Auslass für das Kühlmittel, sodass das Kühlmittel vom Einlass durch den Kühlmittelkanal zum Auslass förderbar ist. Als Kühlmittel wird insbesondere Wasser verwendet.

Im Kühlkörper ist ein Aufnahmemittel für Verbindungsmittel, insbesondere für die Befestigungsschraube und/oder der Gabelsteckvorrichtung und/oder das Targetsegment vorgesehen und der Kühlmittelkanal ist um die Aufnahmemittel herum angeordnet.

Das Aufnahmemittel umfasst Bohrungen für die Befestigungsschraube und/oder Hülse und/oder Ausnehmungen für Targetsegment und/oder Gabelsteckvorrichtung.

Der Kühlmittelkanal ist als offener Kühlmittelkanal ausgebildet, welcher durch ein spanabtragendes Verfahren oder durch ein chemisches Verfahren, insbesondere ein Ätzverfahren, hergestellt wurde. Der offene Kühlmittelkanal wird von einer Kühlkörperaussenwand begrenzt, wobei Kühlkörper und Kühlkörperaussenwand verlötet, verschraubt oder mittels Klemmverbindung gesichert sind und Dichtmittel zwischen Kühlkörper und Kühlkörperaussenwand vorgesehen sind, um den Austritt von Kühlmittel aus dem Kühlkörper zu unterbinden.

Die Kühlkörperaussenwand enthält zumindest eine Bohrung für einen Schraubenkopf der Befestigungsschraube, wobei die Befestigungsschraube durch die Kühlkörperaussenwand, sowie durch den Kühlkörper hindurchgeführt wird, um mit dem Innengewinde der Bohrung in der T-Mutter verschraubt zu werden.

Der Kühlmittelkanal im Kühlkörper ist derart angeordnet, dass die Bohrungen im Kühlkörpergrundmaterial angeordnet sind und/oder in der Bohrung eine Hülse angeordnet ist, wobei die Hülse direkt oder indirekt in wärmeleitendem Kontakt zum Kühlmittel steht.

An der Innenseite des Kühlkörpers sind Aufnahmen für das Targetsegment und/oder die Gabelsteckvorrichtung vorgesehen, wobei die Aufnahmen als Lötstellen oder als Ausnehmungen ausgebildet sind.

Eine Vielzahl von Targetsegmenten ist in der Beschichtungsquelle vorgesehen, die über elektrisch und/oder thermisch leitfähige Mittel in der Targethaltevorrichtung befestigbar sind.

Die T-Mutter, die Kontaktlamellen und/oder die Hülse und/oder die Gabelsteckvorrichtung enthalten eine Kupfer und/oder Nickellegierung, insbesondere eine Kupfer und Beryllium enthaltende Legierung oder eine Kupfer und Beryllium und Kobalt enthaltende Legierung.
Fig. 1 zeigt eine Zusammenstellung einer Targethaltevorrichtung nach einem ersten Ausführungsbeispiel
Fig. 2 zeigt einen Schnitt durch die Targethaltevorrichtung nach Fig. 1
Fig. 3 zeigt eine Zusammenstellung einer Targethaltevorrichtung nach einem zweiten Ausführungsbeispiel
Fig. 4 zeigt einen Schnitt durch die Targethaltevorrichtung nach Fig. 3
Fig. 5 zeigt eine Zusammenstellung einer Targethaltevorrichtung nach einem dritten Ausführungsbeispiel
Fig. 6 zeigt einen Schnitt durch die Targethaltevorrichtung nach Fig. 5
Fig. 7 zeigt eine Zusammenstellung einer Targethaltevorrichtung nach einem vierten Ausführungsbeispiel
Fig. 8 zeigt einen Schnitt durch die Targethaltevorrichtung nach Fig. 7
Fig. 9a zeigt eine weitere Variante für die Verbindung von Targetsegment mit dem Kühlkörper
Fig. 9b zeigt eine weitere Variante für die Verbindung von Targetsegment mit dem Kühlkörper
Fig. 9c zeigt eine weitere Variante für die Verbindung von Targetsegment mit dem Kühlkörper
Fig. 9d zeigt eine weitere Variante für die Verbindung von Gabelsteckvorrichtung mit dem Kühlkörper
Fig. 10a zeigt die T-Mutter, Hülse und Befestigungsschraube gemäss Fig. 1 bis 4
Fig. 10b zeigt eine erste Variante zur Verbindung von Befestigungsschraube mit T-Mutter
Fig. 10c zeigt eine zweite Variante zur Verbindung von Befestigungsschraube mit T-Mutter
Fig. 11a zeigt die Verbindung von Targetsegment mit T-Mutter
Fig. 11b zeigt einen Schnitt durch ein erstes Ausführungsbeispiel einer Verbindung von Targetsegment und T-Mutter.
Fig. 11c zeigt einen Schnitt durch ein zweites Ausführungsbeispiel einer Verbindung von Targetsegment und T-Mutter.
Fig. 11d zeigt einen Schnitt durch ein drittes Ausführungsbeispiel einer Verbindung von Targetsegment und T-Mutter.
Fig. 11e zeigt einen Schnitt durch ein viertes Ausführungsbeispiel einer Verbindung von Targetsegment und T-Mutter.

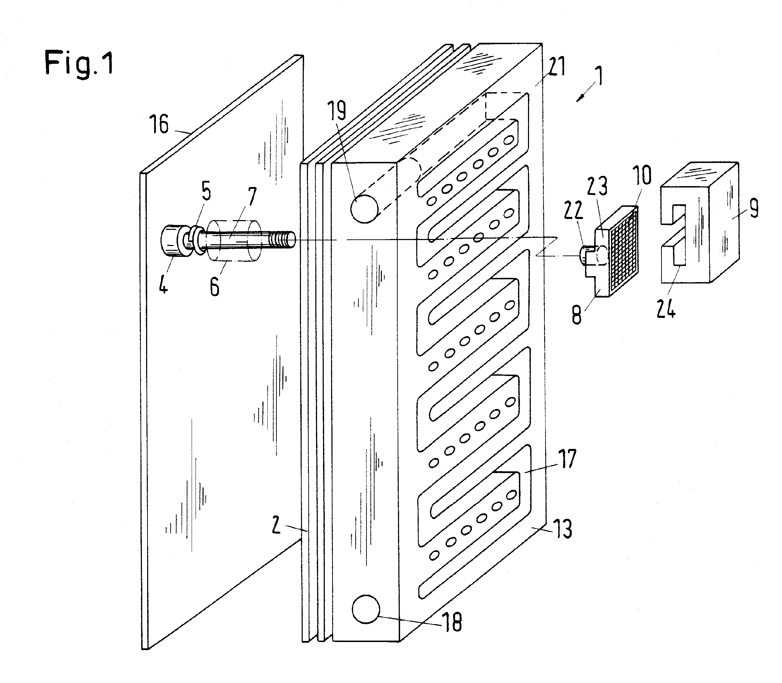

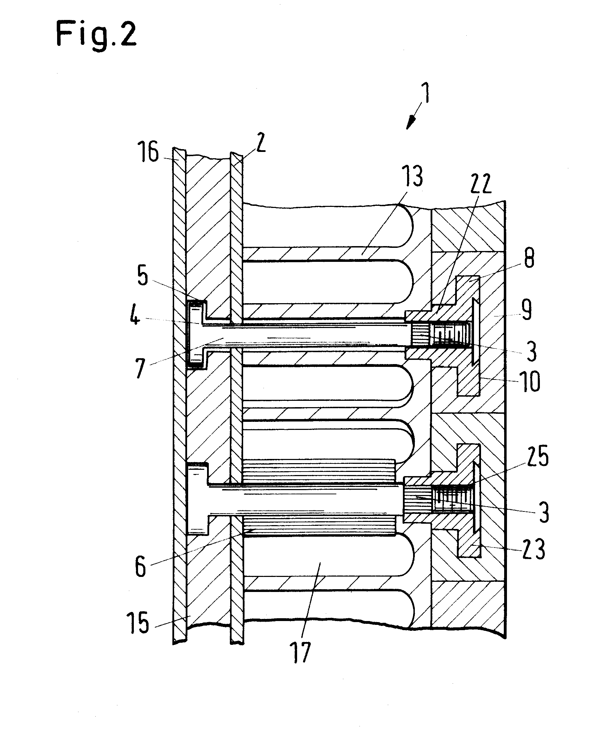

Fig. 1 zeigt die Anordnung eines Targetsegments 9, welches mit einer Targethaltevorrichtung 1 in der Beschichtungsquelle befestigt wird. Jedes Targetsegment 9 wird mittels einer T-Mutter 8, mit der Kühlkörperaussenwand 2 verschraubt. Die T-Mutter besteht aus einem Zylinder 22 und einem Fortsatz 23, welcher einen T-förmigen Querschnitt aufweist. Der Zylinder 22 wird von einer Bohrung im Kühlkörper 13 aufgenommen. Der T-förmige Fortsatz 23 ragt über die Oberfläche der Innenseite des Kühlkörpers 21 hinaus. An der T-Mutter ist eine Kontaktlamelle 10 aus niedrig legiertem Kupfer oder Nickel insbesondere aus CuBe, CuCoBe oder NiBe befestigt und/oder eine galvanische Beschichtung angebracht. Auf die T-Mutter 8 wird zumindest ein Targetsegment 9 aufgesteckt, wobei T-Mutter und Targetsegment einen Zwischenraum aufweisen, in welchem die Kontaktlamelle 10 angeordnet ist. In Fig. 1 wird das Targetsegment 9 auf den T-förmigen Fortsatz 23 gesteckt. Im Targetsegment ist eine Nut 24 angebracht, die eine Erweiterung in der Form eines T aufweist, die passend zu der Form des Fortsatzes 23 ausgestaltet ist. Der T-förmige Fortsatz 23, welcher in einen Zughörige Nut 24 des Targetsegments 9 eingreift, kann zur Aufnahme zumindest eines Targetsegments 9 verwendet werden. Nicht dargestellt ist eine mögliche Variante, in welcher ein T-förmiger Fortsatz 23 zur Aufnahme mehrerer Targetsegmente 9 dient. Ein Targetsegment in gleicher Weise wie die schon aufgesteckten Targetsegmente auf seine Position auf dem T-förmigen Fortsatz 23 verschoben, wobei die Anzahl der Targetsegmente pro T-Mutter von der Segmentbreite abhängig ist, die wiederum mit der Quellengrösse in direkter Beziehung steht. Die Targetsegmente stecken allesamt auf den T-Muttern und/oder zugehörigen Kontaktlamellen und/oder zugehörigen galvanischen Beschichtungen. Jedes der Targetsegmente 9 in einer zur Form des Fortsatzes 23 korrespondierenden Gegenform, wobei in Fig. 1 eine Nut in der Form eines T dargestellt ist, wobei aber auch andere formschlüssige Verbindungen zum Einsatz kommen können, mittels welchen die T-Muttern und/oder Kontaktlamellen zumindest teilweise umgriffen werden. Insbesondere kann im Targetsegment 9 eine Schwalbenschwanznut vorgesehen sein. Die Kontaktlamellen und/oder die galvanische Beschichtung leiten durch ihre guten Wärmeleiteigenschaften die Wärme vom Targetsegment in Richtung des Kühlsystems. Zur Verbesserung des Wärmeübergangs von Targetsegment 9 zu den Kontaktlamellen 10 kann auch auf den Kontaktlamellen eine galvanische Beschichtung vorgesehen sein. Die galvanische Beschichtung befindet sich insbesondere auf der dem oder den Targetsegmenten 9 zugewandten Oberfläche der Kontaktamellen 10. Auf das Targetsegment prallen im Betrieb, also während des Beschichtungsverfahrens, die Ionen eines Inertgases auf. Sie schlagen aus dem Targetsegmentmaterial Atome heraus. Durch die Stösse der auf das Targetsegmentmaterial auftreffenden Ionen kommt es zum Eintrag von Wärmeenergie in das Targetsegment 9, die über die Kontaktlamellen 10, die T-Mutter 8, sowie die Befestigungsschraube 7 zum Kühlkörper 13 abgeführt wird. In Fig. 2 ist die Targethaltevorrichtung 1 aus Fig. 1 im Schnitt dargestellt. In Fig. 2 ist die Befestigungsschraube 7 nur im oberen Teil der Figur dargestellt, im unteren Teil ist die Befestigungsschraube 7 weggelassen, um die Übersichtlichkeit zu erhöhen. Im Innern des insbesondere als Zylinder 22 ausgebildeten Teils der T-Mutter 8 befindet sich ein Innengewinde 25, wie in Fig. 2 dargestellt ist. In das Innengewinde 25 greift das Aussengewinde der Befestigungsschraube ein. Die Befestigungsschraube besteht insbesondere aus Kupfer oder niedrig legiertem Kupfer, wie CuBe, CuCoBe, CuTeP. Der untere Teil der Fig. 2 zeigt in Abwandlung zum oberen Teil den Einbau einer Hülse 6. Diese Hülse 6 wird zusätzlich zur Abfuhr der Wärmeenergie an den Kühlkörper verwendet und wird in der Fachliteratur auch als Einschraublamelle oder Einschraublamellenhülse bezeichnet. Die Hauptfunktion der Hülse 6 besteht darin, den thermischen und elektrischen Kontakt zwischen der Befestigungsschraube 7 und dem Kühlkörper 13 zu verbessern. Die Hülse 6 ist in den Kühlkörper 13 eingeschraubt oder aufgesteckt, sodass durch die Verbindung, die insbesondere als Verschraubung oder als Presspassung ausgeführt ist, ein guter Wärmeübergang gewährleistet ist.

Die Anbindung des Targetsegments 9 an den Kühlkörper 13 und an den Stromkontakt, der nicht dargestellt ist, wird hier durch die Kontaktlamellen 10 zwischen Targetsegment 9 und targetsegmentseitiger Oberfläche des Fortsatzes 23, durch die rückseitige Targetsegmentoberfläche des Targetsgements 9, der T-Mutter 8, über die T-Mutter, das Innengewinde 25 des Zylinders 22 der T-Mutter, sowie einer im Innengewinde 25 angeordneten Kontaktlamelle 3, in die Befestigungsschraube 7 sowie von der Befestigungsschraube 7 direkt an den Kühlköper oder alternativ dazu über die Hülse 6 an den Kühlkörper 13 erzielt. Die Kontaktlamelle 3 ist entweder Teil der Befestigungsschraube 7, wie im oberen Teil der Fig. 2 dargestellt ist, oder aber Teil des Zylinders 22 der T-Mutter 8, wie im unteren Teil der Fig. 2 dargestellt ist. Die Hülse 6 ist in Fig. 2 mit direktem Kontakt zum Kühlmittel dargestellt, welches durch die Kühlmittelkanäle 17 strömt. Durch eine Isolationszone 16 erfolgt die Isolierung der Beschichtungsquelle gegen Entladungen an den Aussenseiten. Die Isolationszone 16 befindet sich an der Aussenwand 15, welche auch Ausnehmungen für die Schraubenköpfe 4 der Befestigungsschrauben 7 enthält.

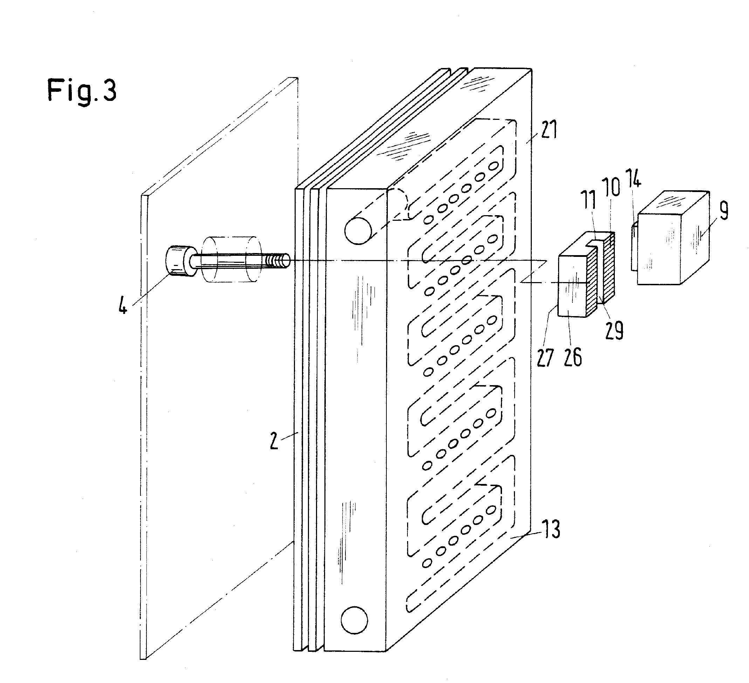

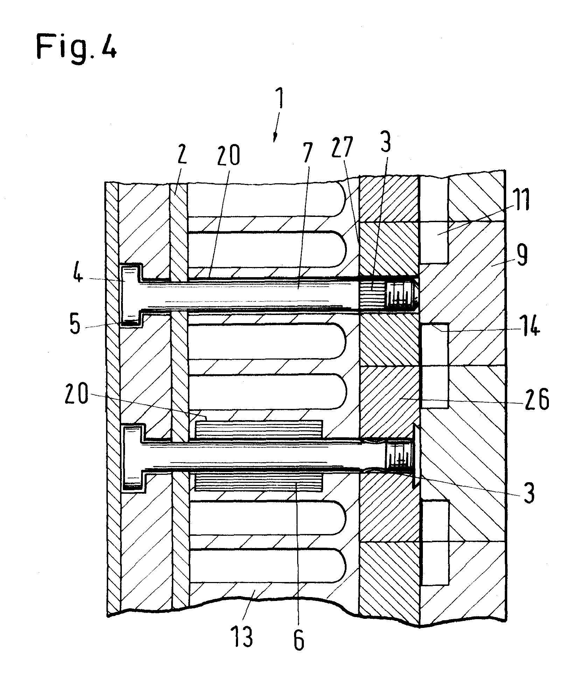

In einem weiteren Ausführungsbeispiel gemäss Fig. 3 und Fig. 4 wird die Anbindung des Targetsegments 9 an den Kühlkörper 13 und an den Stromkontakt, der nicht dargestellt ist, durch ein Verbindungsstück 26 bewirkt. Das Verbindungsstück 26 enthält auf seiner kühlkörperseitigen Oberfläche ein Innengewinde 28, welches zur Aufnahme einer Befestigungsschraube 7 dient, die gleich wie die Befestigungsschraube aus dem Ausführungsbeispiel gemäss Fig. 1 oder 2 ausgebildet ist. Das Verbindungsstück 26 enthält auf seiner kühlkörperseitigen Oberfläche eine Kontaktlamelle 27 und/oder eine galvanische Beschichtung zur Erhöhung des Strom und/oder Wärmedurchgangs. Die Kontaktlamelle 27 braucht sich dabei nicht auf das Innengewinde 27 zu beschränken, sondern kann die gesamte Kontaktoberfläche erfassen. Der Vorteil besteht darin, dass Wärme direkt vom Verbindungsstück 26 an die Innenseite des Kühlkörpers 21 übertragen werden kann. Die Kühlmittelkanäle 17, die in Fig. 3 als nicht sichtbares Element dargestellt sind, befinden sich in der dargestellten Variante gerade in nächster Umgebung zur kühlerseitigen Oberfläche des Verbindungsstücks 26 und dessen Kontaktlamelle 27 und/oder galvanischen Beschichtung. Zwischen Targetsegment 9 und targetsegmentseitiger Oberfläche des Verbindungsstücks 26 werden Kontaktlamellen 11 in einer schlitzartigen Ausnehmung 29 vorgesehen. Die Ausnehmung 29 dient der Aufnahme eines Stegs 14 des Targetsegments 9, der zum Eingriff in die schlitzartige Ausnehmung 29 bestimmt ist.

Der Wärmeübergang erfolgt wie im ersten Ausführungsbeispiel auch zwischen Targetsegment 9 und targetsegmentseitiger Oberfläche der schlitzartigen Ausnehmung 29 über den Steg 14 des Targetsegments, durch das Verbindungsstück 26 über das Innengewinde 28 und einer optional im Innengewinde 28 angeordneten Kontaktlamelle 3 in die Befestigungsschraube 7 sowie von der Befestigungsschraube 7 direkt an den Kühlköper oder alternativ dazu über die Hülse 6 an den Kühlkörper 13. Die Kontaktlamelle 3 ist entweder Teil der Befestigungsschraube 7, wie im oberen Teil der Fig. 4 dargestellt ist, oder aber des Innengewindes 28 des Verbindungsstücks 26, wie im unteren Teil der Fig. 4 dargestellt ist. Die Hülse 6 ist in Fig. 4 nicht mit direktem Kontakt zum Kühlmittel dargestellt, welches durch die Kühlmittelkanäle 17 strömt. Die in Fig. 4 dargestellte Variante der Montage der Hülse 6 ist auch auf das Ausführungsbeispiel gemäss Fig. 2 verwendbar. Die Hülse 6 wird in den Kühlkörper eingeschraubt oder eingepresst. Hierzu sind Aufnahmemittel 20 im Kühlkörper vorgesehen, bei welchen es sich um Bohrungen für die Befestigungsschraube 7 und/oder die Hülse 6 handelt. Alternativ dazu kann die Hülse auch eine feste Verbindung mit der Befestigungsschraube 7 aufweisen, das heisst, eine Schraubverbindung oder vergleichbare formschlüssige Verbindung oder eine Pressverbindung. In die schlitzartige Ausnehmung 29 kann auch eine Gabelsteckvorrichtung 12 aufgenommen werden, wie sie in den nachfolgenden Ausführungsbeispielen beschrieben werden soll. Die Gabelsteckvorrichtung 12 umfasst insbesondere eine schlitzartige Ausnehmung welche Kontaktlamellen an deren Innenseite enthält.

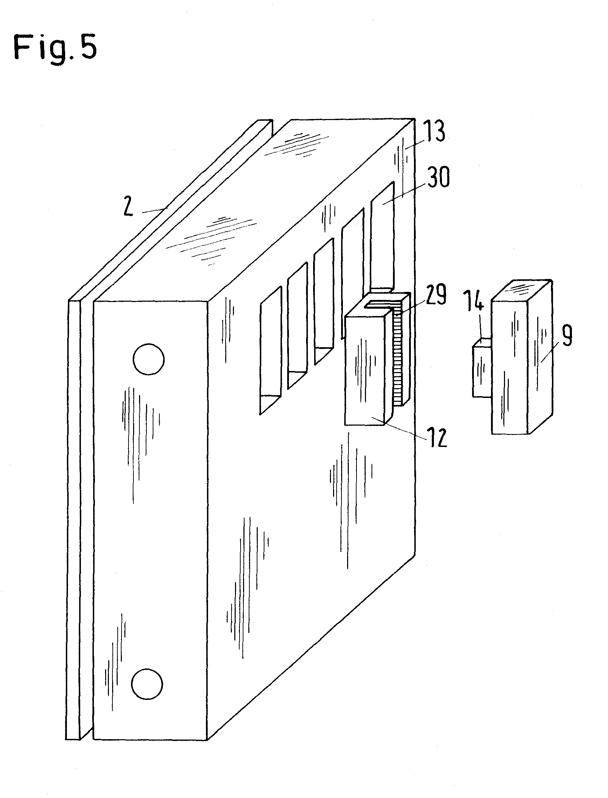

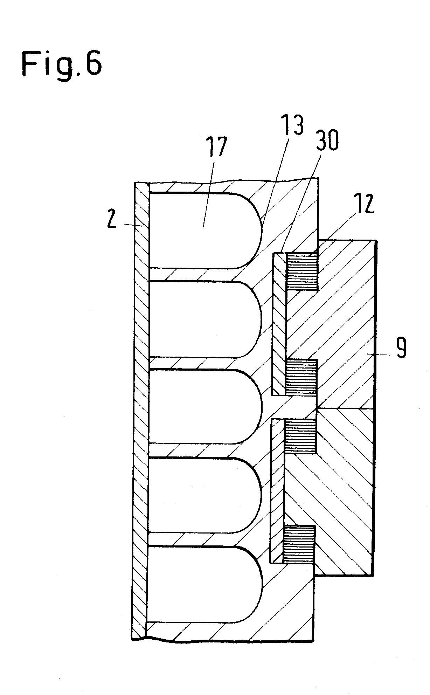

In einem weiteren Ausführungsbeispiel gemäss Fig. 5 ist die Targethaltevorrichtung 1 gleichzeitig als Kühlsystem ausgebildet. Die Targethaltevorrichtung 1 umfasst den Kühlkörper 13 in welchem sich Nuten 30 befinden, in welche zumindest je eine Gabelsteckvorrichtung 12 aufnehmbar ist. Der Kühlkörper 13 besteht aus einem gut wärmeleitenden und elektrisch leitfähigen Material, wie insbesondere Kupfer oder niedrig legiertem Kupfer. Die Gabelsteckvorrichtung 12 ist mit Kontaktlamellen 11 versehen, die ebenfalls aus gut wärmeleitfähigem und elektrisch leitfähigem Material bestehen, insbesondere aus niedrig legiertem Kupfer. Die Kontaktlamellen 11 können zur Herabsetzung des Kontaktwiderstands galvanisch beschichtet sein. Ein derartiger Kontaktwiderstand ist immer zwischen den aneinandergrenzenden Flächen zweier unmittelbar benachbarter, flächig aneinanderliegender Körper vorhanden, insbesondere, wenn es sich um Körper aus verschiedenen Werkstoffen handelt, wie in diesem Fall Targetsegment und Targethaltevorrichtung. An einer derartigen Grenzfläche findet durch die Oberflächenrauhigkeiten und die dadurch bedingten Abstände zur gegenüberliegenden Oberfläche ein verringerter Wärmeübergang statt, der durch die galvanische Beschichtung, d.h. dem Auffüllen dieser Oberflächenrauhigkeiten verbessert werden kann. Im vorliegenden Ausführungsbeispiel entfallen wie in Fig. 6 gezeigt wird, die T-Muttern sowie die Befestigungsschrauben. Der Steg 14 des Targetsegments 9 erstreckt sich in Fig. 5 oder 6 nicht über die gesamte Höhe des Targetsegments. Es ist möglich, in den Zwischenräumen weitere Verbindungsmittel vorzusehen, die nicht im einzelnen dargestellt sind. So könnten konische Schieber, Exzenterwellen, Arretierungen mittels Steckkontakten, Zugfedern oder pneumatisch arbeitende Platten verwendet werden, um eine einen guten Halt des Targetsegments 9 in der Gabelsteckvorrichtung 12 zu gewährleisten. Alternativ dazu besteht auch die Möglichkeit, eines der vorgenannten Verbindungsmittel oder eine Kombination derselben anstatt der Gabelsteckvorrichtung 12 vorzusehen, sodass das Targetsegment im Kühlkörper 13 selbst befestigt wird.

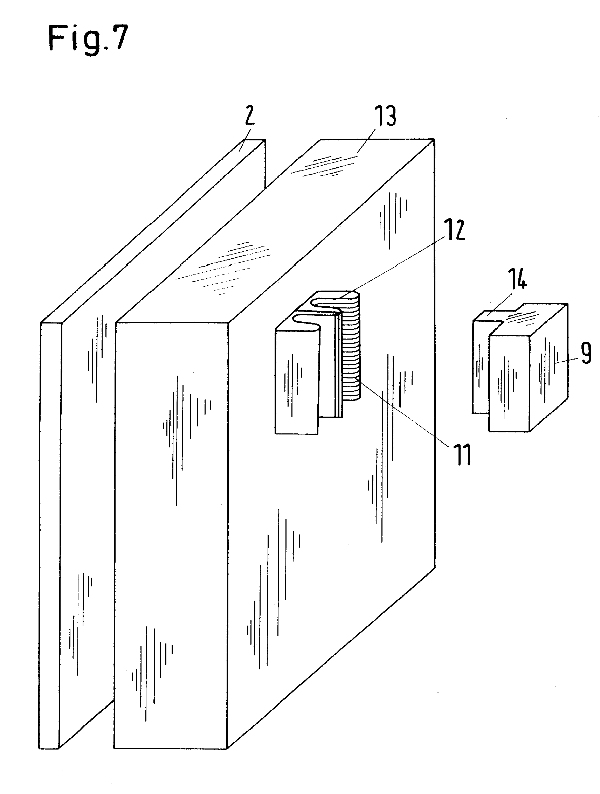

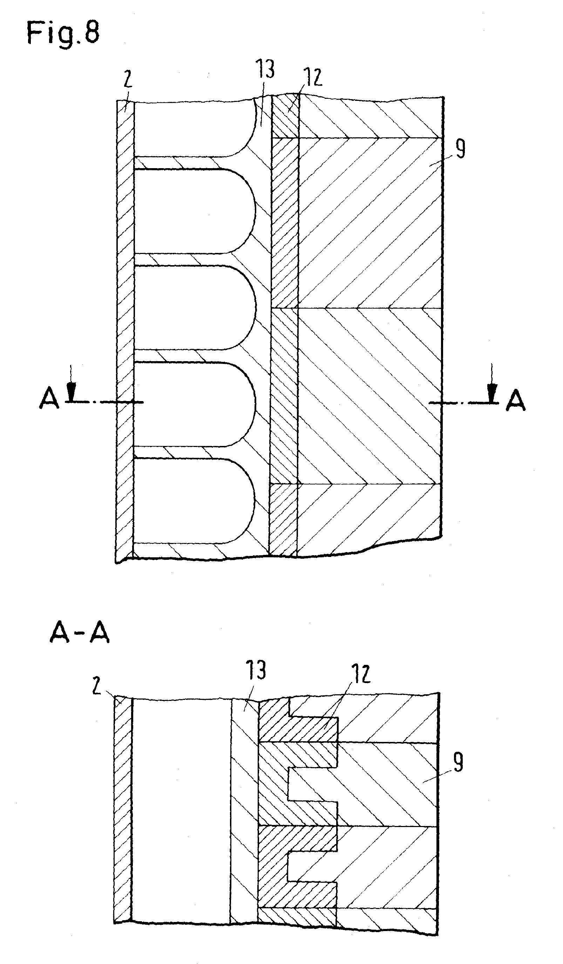

Nach einem weiteren Ausführungsbeispiel gemäss Fig. 7 und Fig. 8 können die Targetsegmente direkt auf den Kühlkörper 13 aufgesteckt werden. Bei bestimmten Materialien ergibt sich diese Notwendigkeit aus Gründen der Bearbeitbarkeit. Zusätzlich können durch die Gestaltung der Steckverbindung die Bearbeitungskosten gesenkt werden, sowie der Materialaufwand verringert werden und vereinfacht sich die Montage. Die Anbindung der Targetsegmente an Kühlkörper und Stromanschluss erfolgt direkt über die ausgearbeiteten Stege 14 mittels der Gabelsteckvorrichtungen 12. Die Anbringung der Gabelsteckvorrichtungen 12 am Kühlkörper erfolgt im Unterschied zu dem vorherigen Ausführungsbeispiel nicht durch Einstecken in Nuten des Kühlkörpers sondern durch eine Haftverbindung, wie beispielsweise eine Klebeverbindung. Kontaktlamellen 11, sogenannte Gabelstecklamellen, werden in den Gabelsteckvorrichtungen 12 eingebracht. Alternativ dazu ist es möglich, die Gabelsteckvorrichtungen auf den Kühlkörper entweder aufzulöten, anzuschrauben, oder aus diesem mittels eines spanabhebenden Verfahrens, wie beispielsweise Fräsen, aus dem Kühlkörper herauszuarbeiten.

In diese Gabelsteckvorrichtungen werden die Targetsegmente direkt eingesteckt und fixiert. Die Targetsegmente werden durch geeignete Bearbeitungsmethoden (je nach Material: z.B.: EDM, Fräsen) so ausgearbeitet, dass ihr Steg genau und kontaktfest in die Gabelsteckvorrichtung 12 des Kühlkörpers 13 passt. Als Bearbeitungsmethoden für das Targetsegment kommen insbesondere Fräsen oder EDM (electron discharge machining) zum Einsatz. Electron Discharge Machining ist ein Hochpräzisionsbearbeitungsprozess, mittels welchem Material geschnitten oder gebohrt wird. Mittels elektrophysikalischem Verdampfen durch Anlegen einer elektrischen Spannung an eine Elektrode wird eine Bearbeitung selbst äusserst harter, zäher oder brüchiger Materialsorten ermöglicht.

Die Targetsegmente 9 können nach jedem der vorhergehenden Ausführungsbeispiele in die Targethaltevorrichung 1 eingesteckt werden, und auf diese Weise auch wieder entnommen werden. Einzelne Targetsegmente können daher in allen Versionen auch völlig unabhängig von den anderen Targetsegmenten ersetzt werden. Durch den flächigen Kontakt von den Targetsegmenten zu den Gabelsteckvorrichtungen ergibt sich eine grosse effektive Wärmeübergangsfläche, sodass die Targethaltevorrichtung direkt an das Kühlsystem angebunden wird. Die im Targetsegment entstehende Wärme kann dann einfach abgeführt werden, sodass eine hohe Kühlrate erzielbar ist.

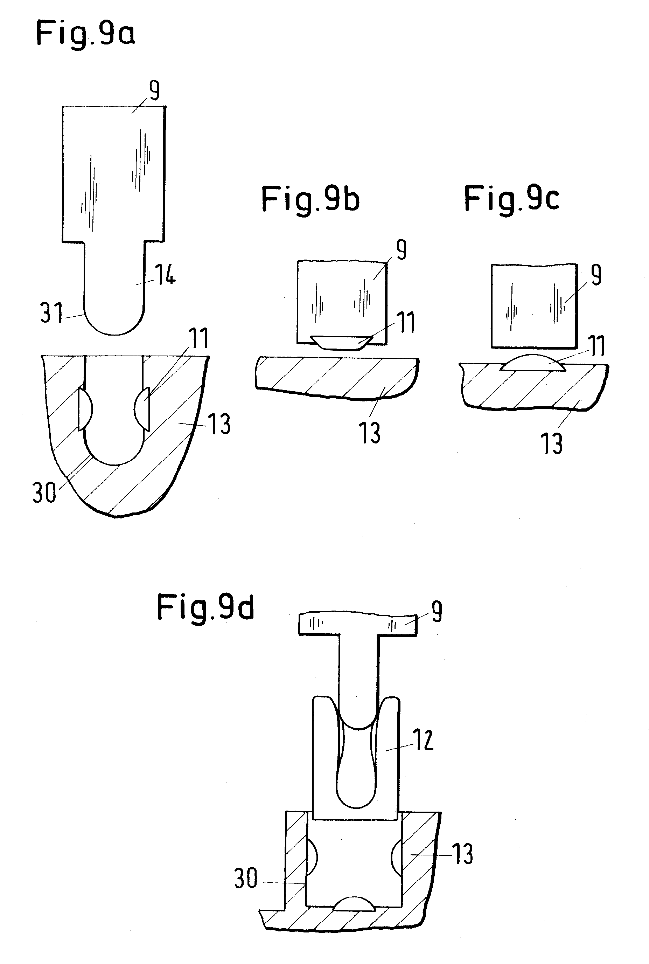

Fig. 9a zeigt eine weitere Variante für die Verbindung von Targetsegment 9 mit dem Kühlkörper 13. Im Kühlkörper 13 befindet sich eine Nut 30, in welche ein Steg 14 mit abgerundeter Oberfläche 31 formschlüssig eingreift. In der Nut 30 sind Kontaktlamellen 11 angeordnet. Die Kontaktlamellen 11 verbessern den Halt des Targetsegments 9 in der Nut 30 und erlauben eine präzise Einpassung der beiden Teile. Zusätzlich kann in der Nut eine galvanische Beschichtung und/oder ein wärmeleitendes, zähflüssiges oder pastöses Fluid zur Verbesserung des Wärmeübergangs vor dem Zusammenfügen des Targetsegments mit dem Kühlkörper eingebracht werden. Vorteilhafterweise handelt es ich um eine lösbare Verbindung, sodass ein verbrauchtes Targetsegment einfach ausgetauscht werden kann.

In Fig. 9b ist dargestellt, dass eine Kontaktlamelle 11 auch auf dem Targetsegment 9 selbst angebracht sein kann. Die Befestigung des Targetsegments 9 am Kühlkörper ist nicht dargestellt. Eine derartige Kontaktlamelle kann in jedem der Ausführungsbeispiele nach Fig. 1 bis Fig. 8 zum Einsatz kommen.

In Fig. 9c ist dargestellt, dass eine Kontaktlamelle 11 der Oberfläche des Kühlkörpers 13 selbst angebracht sein kann. Die Befestigung des Targetsegments 9 am Kühlkörper 13 ist nicht dargestellt. Eine derartige Kontaktlamelle kann in jedem der Ausführungsbeispiele nach Fig. 1 bis Fig. 8 zum Einsatz kommen. In Fig. 1 oder 2 wird durch die Anbringung einer derartigen Kontaktlamelle in den Bereichen des Targetsegments, die direkt an den Kühlkörper 13 angrenzen, einen Wärmeübergang zusätzlich zum Wärmeübergang über die T-Mutter 8 und die Befestigungsschraube 7 bewirken.

Fig. 9d zeigt eine Kombination des in Fig. 9a gezeigten Stegs 14 mit einer Gabelsteckvorrichtung 12, die nach einer der Fig. 5 bis 8 angeordnet sein kann. Kontaktlamellen können am Nutgrund oder jeder der Wände der Nut 30 angebracht sein. Die Verwendung von Kontaktlamellen in der Gabelsteckvorrichtung kann unabhängig von der in Fig. 9d gezeigten Anordnung vorgenommen werden.

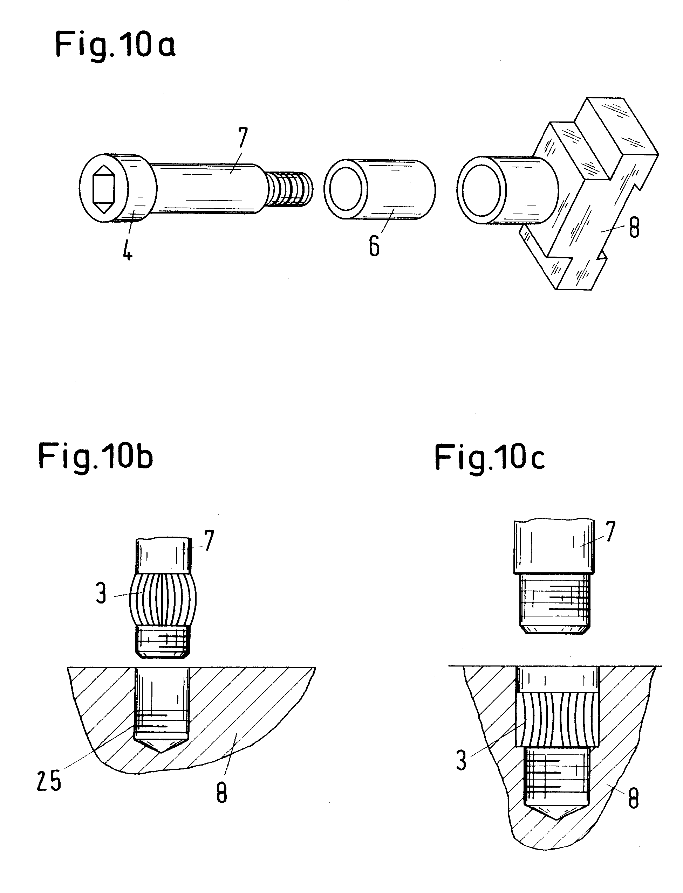

Fig. 10a zeigt die T-Mutter, Hülse und Befestigungsschraube gemäss den Ausführungsbeispielen aus Fig. 1 bis 4 in einer Explosionsdarstellung. Die Hülse 6 wird in diesem Fall auf die Befestigungsschraube 7 gesteckt, bevor der Zusammenbau mit dem nicht dargestellten Kühlkörper und der T-Mutter 8 erfolgt.

Fig. 10b zeigt eine erste Variante zur Verbindung von Befestigungsschraube mit T-Mutter. Die T-Mutter 8 ist im Schnitt dargestellt, wobei auf Einzelheiten, wie die Darstellung des Zylinders 22 verzichtet wurde. Im vorliegenden Fall wird ein Sackloch mit Gewinde verwendet. Alternativ dazu besteht die Möglichkeit, eine Durchgangsbohrung in der T-Mutter 8 vorzusehen, wie es in Fig. 2 und Fig. 4 gezeigt wurde. Die Auswahl hängt hauptsächlich von der Grösse der verwendeten T-Mutter und dem damit verbundenen Zeitaufwand für den Materialabtrag zusammen. Die Spitze der Befestigungsschraube 7 weist eine Kontaktlamelle 3 auf, welche an das Aussengewinde zum Einschrauben der Befestigungsschraube 7 in das Innengewinde 25 der T-Mutter anschliesst.

In Fig. 10c ist eine zweite Variante zur Verbindung von Befestigungsschraube 7 mit T-Mutter 8 dargestellt. Im Unterschied zu Fig. 10b ist eine Kontaktlamelle 3 in der Sacklochbohrung der T-Mutter 8 angeordnet. Das Aussengewinde der Befestigungsschraube 7 ist von kleinerem Durchmesser als der Schraubenhals, damit durch die Kontaktlamelle 3 das Gewinde keinen Schaden nehmen kann. Auch in den in Fig. 10b oder 10c dargestellten Varianten kann es vorteilhaft sein, eine wärmeleitendes zähflüssiges Fluid in den Bereich des Gewindes einzubringen, um den Wärmeübergang im Gewindebereich zu verbessern.

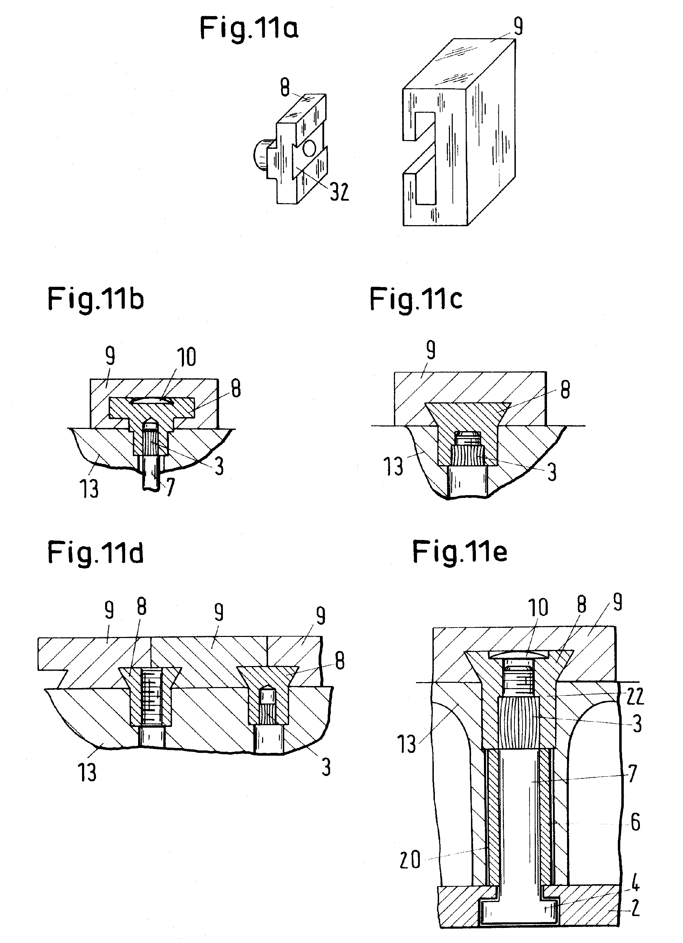

Fig. 11a zeigt noch einmal schematisch die Verbindung von Targetsegment 9 mit T-Mutter 8 gemäss Fig. 1 oder 2. Die Ausnehmung 32 dient der Aufnahme einer Kontaktlamelle 10.

Fig. 11b zeigt die Verwendung eines Sacklochs nach der Ausführung von Fig. 10b und den Einbau einer Kontaktlamelle 10 in der Ausnehmung 32 zur Verbesserung des Wärmeübergangs von Targetsegment 9 auf T-Mutter 8.

Fig. 11b zeigt eine Schwalbenschwanznut 24 als Nut im Targetsegment. Der Kopf der T-Mutter hat einen Querschnitt, der genau der Schwalbenschwanznut im Targetsegment entspricht, sodass sich eine genaue Passung der beiden Teile ergibt. Zudem ist in Fig. 11 b die in Fig. 10c dargestellte Verbindung der Befestigungsschraube mit der T-Mutter dargestellt.

Fig. 11c zeigt eine Variante für die Befestigung der Targetsegmente 9 an einer T-Mutter mit einem Kopf mit einer Ausgestaltung zur Einpassung in eine Schwalbenschwanznut des Targetsegments. Allerdings wird je eine T-Mutter von zwei benachbarten Targetsegmenten benutzt. Diese Lösung ist insbesonder dann vorteilhaft, wenn sich das Targetsegmentmaterial nicht eignet, teilweise hohle Strukturen, wie T-förmige Nuten oder Schwalbenschwanznuten, herzustellen. Targetsegmentmaterial muss ausschliesslich von je zwei Kanten des Targetsegments abgetragen werden, was die Bearbeitung des Targetsegments wesentlich vereinfacht.

Auch in Fig. 11d sind zwei Varianten der Verbindung der T-Mutter mit der Befestigungsschraube 7 dargestellt, eine Variante mit Durchgangsbohrung ist linksseitig abgebildet, eine Variante mit Sackloch in der T-Mutter ist rechtsseitig abgebildet. Beispielhaft ist eine Kontaktlamelle 3 dargestellt. Kontaktlamellen gemäss Fig. 9a oder Fig. 9b können bei der in Fig. 11d gezeigten Anordnung gleicherweise zum Einsatz kommen.

Fig. 11e zeigt eine der Fig. 2 entsprechende Schnittdarstellung einer T-Mutter 8 mit Schwalbenschwanzkopf. Zwischen Targetsegment 9 und T-Mutter befindet sich eine Kontaktlamelle 10. Die T-Mutter weist eine zentral angeordnete Durchgangsbohrung für die Aufnahme der Befestigungsschraube 7 auf. Die Befestigungsschraube 7 weist im Bereich der T-Mutter anstatt eines Gewindes teilweise eine Kontaktlamelle 3 auf, welche in einer Bohrung der T-Mutter angeordnet ist. Die T-Mutter reicht zumindest mit ihrem Zylinder 22 in den Kühlkörper 13, in welchem sie aufgenommen ist. An die T-Mutter schliesst die Hülse 6 an, welche der Verbesserung des Wärmeübergangs von Befestigungsschraube 7 an die Kühlkörperwand dient. Die Hülse 6 ist in einem Aufnahmemittel 20 im Kühlkörper aufgenommen. Der Schraubenkopf 4 der Befestigungsschraube befindet sich in einer Bohrung der Kühlkörperaussenwand 2, die den Innenraum des Kühlkörpers fluiddicht abschliesst.

### Bezugszeichenliste

- 1.: Targethaltevorrichtung
- 2.: Kühlkörperaussenwand
- 3.: Kontaktlamelle
- 4.: Schraubenkopf der Befestigungsschraube
- 5.: Tellerfeder
- 6.: Hülse
- 7.: Befestigungsschraube
- 8.: T-Mutter
- 9.: Targetsegment
- 10.: Kontaktlamelle für T-Mutter
- 11.: Kontaktlamelle für Targetsegment
- 12.: Gabelsteckvorrichtung
- 13.: Kühlkörper
- 14.: Steg
- 15.: Aussenwand
- 16.: Isolationszone
- 17.: Kühlmittelkanal
- 18.: Einlass Kühlmittel
- 19.: Auslass Kühlmittel
- 20.: Aufnahmemittel
- 21.: Innenseite des Kühlkörpers
- 22.: Zylinder der T-Mutter
- 23.: Fortsatz
- 24.: Nut im Targetsegment
- 25.: Innengewinde T-Mutter
- 26.: Verbindungsstück
- 27.: Kontaktlamelle
- 28.: Innengewinde Verbindungsstück
- 29.: schlitzartige Ausnehmung
- 30.: Nut
- 31.: abgerundete Oberfläche
- 32.: Ausnehmung

## Patentansprüche

1. Vorrichtung zur Befestigung von einem Target oder Targetsegment (9) einer Beschichtungsquelle umfassend ein Target oder Targetsegment (9) und eine Targethaltevorrichtung (1), welche einen Kühlkörper (13) und Verbindungsmittel (6,7,8,11) zur Befestigung des Targets oder Targetsegments am Kühlkörper umfasst, **dadurch gekennzeichnet, dass** die Verbindungsmittel (3,6,7,8,10,11) elektrisch und/oder thermisch leitfähige Mittel umfassen, sodass die Stromzufuhr in einer gleichmässigen Verteilung über das Target oder Targetsegment erfolgt, sowie die während des Beschichtungsverfahrens am Target oder Targetsegment entstehende Wärme gleichmässig in den Kühlkörper abführbar ist.

2. Vorrichtung nach Anspruch 1, umfassend eine T-Mutter (8) zur Aufnahme einer Befestigungsschraube (7) zur Verbindung von Targetsegment mit Kühlkörper (13).

3. Vorrichtung nach Anspruch 2, wobei die T-Mutter und/oder die Befestigungsschraube (7) eine Kontaktlamelle (3) aufweisen, wobei durch die Kontaktlamelle (3) ein strom-und wärmeleitender Kontakt zwischen T-Mutter und Befestigungsschraube und/oder Targetsegment (9) herstellbar ist.

4. Vorrichtung nach Anspruch 1 wobei die T-Mutter eine galvanische Beschichtung im Kontaktbereich von T-Mutter mit Befestigungsschraube und/oder T-Mutter und Kühlkörper und/oder T-Mutter und Targetsegment aufweist und/oder der Kühlkörper (13) und/oder das Targetsegment (9) zumindest an den gemeinsamen Kontaktflächen eine galvanische Beschichtung aufweist.

5. Vorrichtung nach einem der vorhergehenden Ansprüche, wobei die Befestigungsschraube (7) im Bereich der Durchtrittsbohrung durch den Kühlkörper von einer Hülse umgeben ist (6), wobei die Hülse als hohlzylindrischer Körper ausgebildet sein kann, der insbesondere ein Aussengewinde enthält, womit die Hülse in eine Bohrung im Kühlkörper einschraubbar ist und durch welche die Befestigungsschraube passgenau hindurchsteckbar ist, oder die Hülse zusammen mit der Befestigungsschraube in eine Gewindebohrung des Kühlkörpers einschraubbar ist, sodass ein guter Wärmeübergang von der Befestigungsschraube in den Kühlkörper zur Ableitung der Wärme vom Targetsegment erfolgt.

6. Vorrichtung nach einem der vorhergehenden Ansprüche, wobei die elektrisch und/oder thermisch leitfähigen Mittel eine Gabelsteckvorrichtung (12) zum Einstecken eines Targetsegments in den Kühlkörper (13) umfassen.

7. Vorrichtung nach einem der vorhergehenden Ansprüche, wobei eine Kontaktlamelle (11) zwischen Targetsegment (9) und Kühlkörper (13) angeordnet ist, insbesondere innerhalb der Gabelsteckvorrichtung (12) und/oder in einer Ausnehmung des Kühlkörpers und/oder des an den Kühlkörper anschliessenden Targetsegments und/oder der zwischen Kühlkörper und Targetsegment angeordneten T-Mutter angeordnet ist.

8. Vorrichtung nach Anspruch 7, wobei die Kontaktlamelle (11) ein Federelement umfasst, wodurch der Wärmeübergang zwischen den benachbarten Oberflächen des Kühlkörpers (13) und/oder des Targetsegments (9) und/oder T-Mutter (10) und/oder der Gabelsteckvorrichtung (12) verbesserbar ist.

9. Vorrichtung nach Ansprüchen 7 oder 8, wobei die Gabelsteckvorrichtung (12) auf den Kühlkörper aufgelötet und/oder, in einer Ausnehmung des Targetsegments eingesteckt und/oder mit dem Kühlkörper verschraubbar ist.

10. Vorrichtung nach einem der vorhergehenden Ansprüche, wobei zumindest ein Kühlmittelkanal (17) zur Förderung des Kühlmittels durch den Kühlkörper (13) vorgesehen ist und der Kühlkörper (13) zumindest einen Einlass (18) und einen Auslass (19) für das Kühlmittel, insbesondere Wasser, umfasst, sodass das Kühlmittel vom Einlass (18) durch den Kühlmittelkanal (17) zum Auslass förderbar ist.

11. Vorrichtung nach einem der vorhergehenden Ansprüche, wobei im Kühlkörper Aufnahmemittel (20) für Verbindungsmittel, insbesondere für die Befestigungsschraube (7) und/oder der Gabelsteckvorrichtung (12) und/oder des Targetsegments (9) vorgesehen sind und der Kühlmittelkanal (17) um die Aufnahmemittel (20) herum angeordnet ist.

12. Vorrichtung nach einem der vorhergehenden Ansprüche, wobei die Aufnahmemittel Bohrungen für die Befestigungsschraube (7) und/oder Hülse (6) und/oder Ausnehmungen für Targetsegment (9) und/oder Gabelsteckvorrichtung (12) umfassen.

13. Vorrichtung nach einem der vorhergehenden Ansprüche, wobei der Kühlmittelkanal als offener Kühlmittelkanal ausgebildet ist, welcher durch ein spanabtragendes Verfahren oder durch ein chemisches Verfahren, insbesondere ein Ätzverfahren, hergestellt wurde und der offene Kühlmittelkanal von einer Kühlkörperaussenwand (2) begrenzt wird, wobei Kühlkörper (13) und Kühlkörperaussenwand (2) verlötet, verschraubt oder mittels Klemmverbindung gesichert sind und Dichtmittel zwischen Kühlkörper und Kühlkörperaussenwand vorgesehen sind, um den Austritt von Kühlmittel aus dem Kühlkörper zu unterbinden.

14. Vorrichtung nach Anspruch 13, wobei die Kühlkörperaussenwand (2) zumindest eine Bohrung für einen Schraubenkopf (4) der Befestigungsschraube (7) enthält, wobei die Befestigungsschraube durch die Kühlkörperaussenwand (2), sowie durch den Kühlkörper hindurchgeführt wird, um mit dem Innengewinde der Bohrung in der T-Mutter (8) verschraubt zu werden.

15. Vorrichtung nach Ansprüchen 13 oder 14, wobei der Kühlmittelkanal im Kühlkörper derart angeordnet ist, dass die Bohrungen im Kühlkörpergrundmaterial angeordnet sind und/oder in der Bohrung eine Hülse (6) angeordnet ist, wobei die Hülse direkt oder indirekt in wärmeleitendem Kontakt zum Kühlmittel steht.

16. Vorrichtung nach einem der vorhergehenden Ansprüche, wobei an der Innenseite (21) des Kühlkörpers (13) Aufnahmen für das Targetsegment (9) und/oder Gabelsteckvorrichtung (12) vorgesehen sind, wobei die Aufnahmen als Lötstellen oder als Ausnehmungen ausgebildet sind.

17. Vorrichtung nach einem der vorhergehenden Ansprüche, wobei eine Vielzahl von Targetsegmenten (9) in der Beschichtungsquelle vorgesehen ist, die über elektrisch und/oder thermisch leitfähige Mittel nach einem der vorhergehenden Ansprüche in der Targethaltevorrichtung (1) befestigbar sind.

18. Vorrichtung nach einem der vorhergehenden Ansprüche, wobei die T-Mutter (8), die Kontaktlamellen (3,10) und/oder die Hülse (2) und/oder die Gabelsteckvorrichtung (12) eine Kupfer und/oder Nickellegierung enthalten, insbesondere eine Kupfer und Beryllium enthaltende Legierung oder eine Kupfer und Beryllium und Kobalt enthaltende Legierung enthalten.
